# EUROPEAN PATENT APPLICATION

(11) **EP 0 932 191 A1**
(43) Date of publication of application: **28.07.1999**
(21) Application number: 97480107.8
(22) Date of filing: 30.12.1997
(51) Int. Cl.: H01L 21/321, H01L 21/768

(54) **Method of plasma etching doped polysilicon layers with uniform etch rates**

(71) Applicant: INTERNATIONAL BUSINESS MACHINES CORPORATION, Armonk, NY 10504 (US)
(72) Inventor: Leverd, François, 77240 Cesson (FR); Maccagnan, Renzo, 91100 Villabé (FR); Mass, Eric, 75006 Paris (FR)
(74) Representative: Klein, Daniel Jacques Henri

(57) **Abstract**

In wafer semiconductor manufacture, a method of etching an arsenic doped polysilicon layer down to a patterned boro-phospho-silicate-glass (BPSG) layer provided with a plurality of openings with an uniform etch rate is disclosed. The method relies on a combination of both system and process improvements. The system improvement consists to hold the wafer in the reactor during the etch process with an electrostatic chuck device to have a perfect plasma environment around and above the wafer. On the other hand, the process improvement consists in the use of a non dopant sensitive and not selective chemistry. A NF3/CHF3/N2 gas mixture with a 11/8.6/80.4 ratio in percent is adequate in that respect. The etch time duration is very accurately controlled by an optical etch endpoint detection system adapted to detect the intensity signal transition of a CO line at the BPSG layer exposure. The process is continued by a slight overetching. When the above method is applied to the doped polysilicon strap formation in DRAM chips, excessive or insufficient etching of the polysilicon layer is avoided, so that the doped polysilicon strap thickness is thus much more uniform, opening to opening, within a wafer.

## Description

### FIELD OF INVENTION

The present invention relates to the manufacture of semiconductor integrated circuits (ICs) and more particularly to a method of plasma etching a doped polysilicon layer formed on a patterned dielectric layer with an uniform etch rate. The method finds a very useful application in forming doped polysilicon straps in a boro-phospho-silicate glass (BPSG) layer provided with strap openings with a high level of thickness uniformity in DRAM chips.

### BACKGROUND OF THE INVENTION

In the manufacture of semiconductor integrated circuits, and particularly in Dynamic Random Access Memory (DRAM) chips, polysilicon straps are extensively used. In DRAM chips, an Insulated Gate Field Effect Transistor (IGFET) and a storage capacitor associated thereto form the elementary memory cell. Polysilicon straps are built between the drain region of the IGFET transistor and an electrode of the capacitor to allow an electrical contact therebetween.

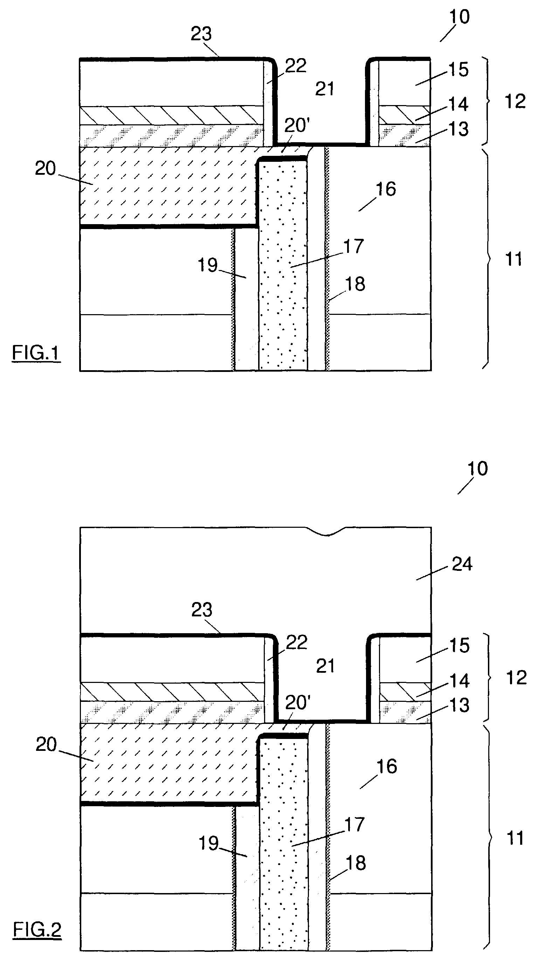

The essential steps of a conventional polysilicon strap (PS) formation process will be briefly described by reference to Figs. 1 to 8. After these steps have been completed, the surface electrode of each storage capacitor is connected to the drain region of its corresponding IGFET transistor.

Fig. 1 schematically illustrates a semiconductor structure 10 which is a part of a wafer at the initial stage of the PS fabrication process. Structure 10 basically comprises a silicon substrate 11 with the gate conductor stack 12 formed thereon. The latter consists of a bottom 100 nm thick polysilicon layer 13, a 80 nm thick tungsten silicide layer 14, and a top 230 nm silicon nitride layer 15. Buried in the silicon substrate 11, is a conventional storage capacitor 16 usually referred to as a "deep trench" capacitor. A doped polysilicon fill 17 will act as a first electrode of the capacitor. The polysilicon fill 17 is isolated from silicon substrate 11 on a major portion of its lateral side by a classic NO (Nitride/Oxide) layer and a TEOS SiO2 collar layer respectively referenced 18 and 19. As apparent from Fig. 1, a recess filled with TEOS SiO2 material forms isolation region 20 to terminate the lateral isolation of the capacitor. Region 20 further provides a cap at the polysilicon fill 17 top surface that is referenced 20'. An opening 21 has been made in the gate conductor stack 12. The lateral walls of this opening are coated with a 100 nm thick silicon nitride layer to form spacer 22. A very thin (a few nm) oxi-nitride barrier liner 23 has been blanket deposited onto the structure.

Now, the structure 10 is coated with a 400 nm thick boro-phospho-silicate glass (BPSG) layer 24 as shown in Fig. 2.

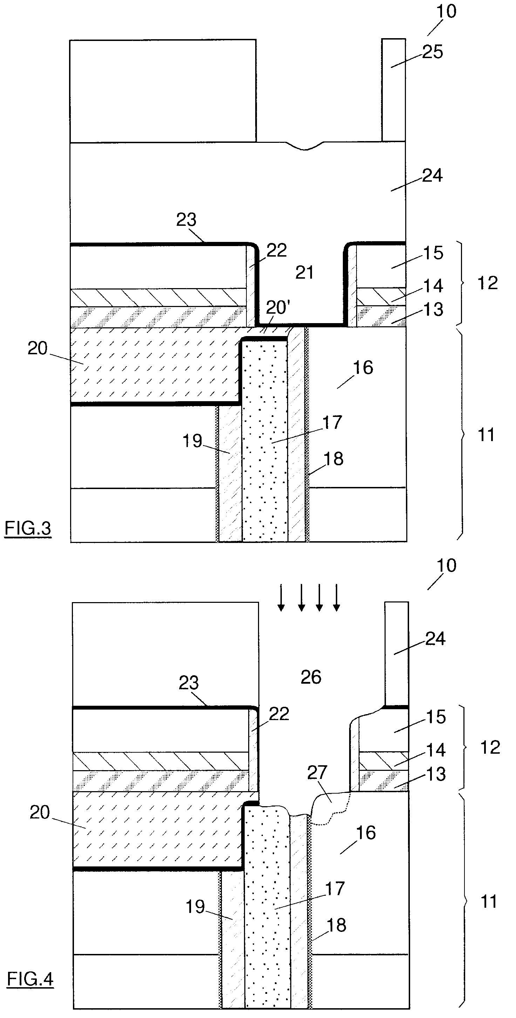

Then, referring to Fig. 3, the structure is coated with a photosensitive material. An adequate material is the photoresist labelled THNR IP 3650 TOK, manufactured and sold by TOKYO OHKA KOGIO Ltd, Tokyo, Japan. A thickness of about 850 nm is adequate. After deposition, the photoresist layer 25 is baked, exposed and developed as standard to leave the patterned layer or mask referenced 25. The purpose of this mask 25 is to define the locations of the straps at the surface of the silicon substrate 11 in opening 21.

Next, after the SS mask 25 has been defined, the process continues with an etch step to expose the top surface of the polysilicon fill 17. The wafer is placed in a TEL 85 SDRM, a RIE etcher manufactured by TOKYO ELECTRON Lted, Tokyo, Japan, with a C4F8/CO/Ar chemistry. It is a very aggressive etching mixture which strongly attacks the BPSG layer 24. During this step, the oxi-nitride liner 23 and the TEOS SiO2 cap portion 20' are removed in opening 21. As a result of this etching step, an opening, referred to as the strap opening, referenced 26 in Fig. 4 is formed, which exposes a portion of the silicon substrate 11 and the polysilicon fill 17 top surface. At this stage of the PS fabrication process, an implant of phosphorous ions is performed. The areas of the silicon substrate 11 that are not protected are N-type doped, forming thereby the source and drain regions of the IGFET transistor, as illustrated by drain region 27 in Fig.4.

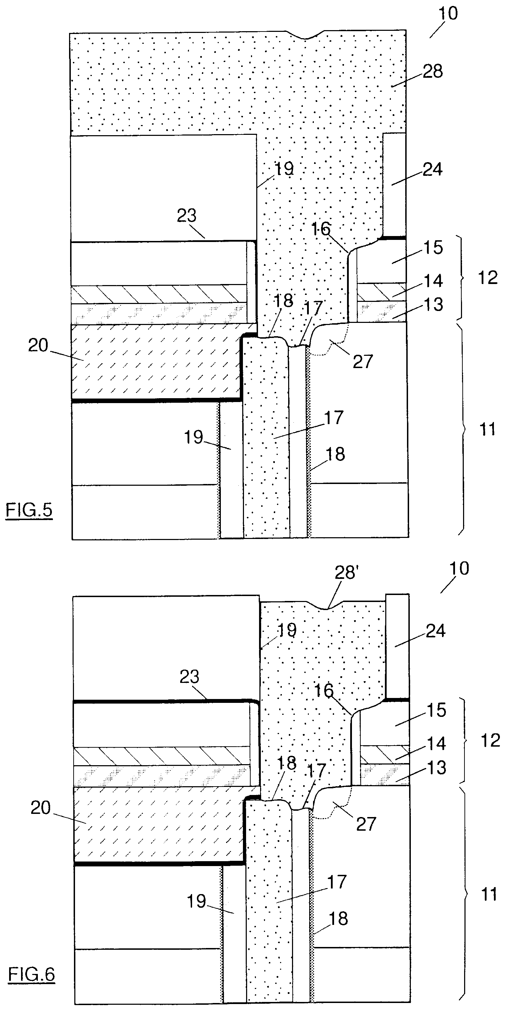

A 400 nm thick arsenic-doped polysilicon layer 28 is then conformally deposited by LPCVD onto the structure 10, as apparent in Fig. 5,

Now, a polysilicon plug filling opening 26 is formed. To that end, structure 10 is placed in an AME 5000 mark II, a MERIE plasma etcher manufactured by Applied Materials Inc., Santa Clara, CA, USA and etched with an appropriate SF6 chemistry according to a two-step process.

The aim of the first sub-step is to uniformly remove the doped polysilicon material of layer 28 approximately down to the BPSG layer 24 top surface for a coarse planarization. To that end, SF6 gas is used because it etches the doped polysilicon much faster than the BPSG material (etch ratio is 8:1). The resulting structure is shown in Fig. 6, where the polysilicon plug filling opening 26 is referenced 28'.

Process parameters for this first step reads as follows:
- SF6: : 90 sccm
- Pressure: : 200 mTorr
- RF power: : 70 Watt.

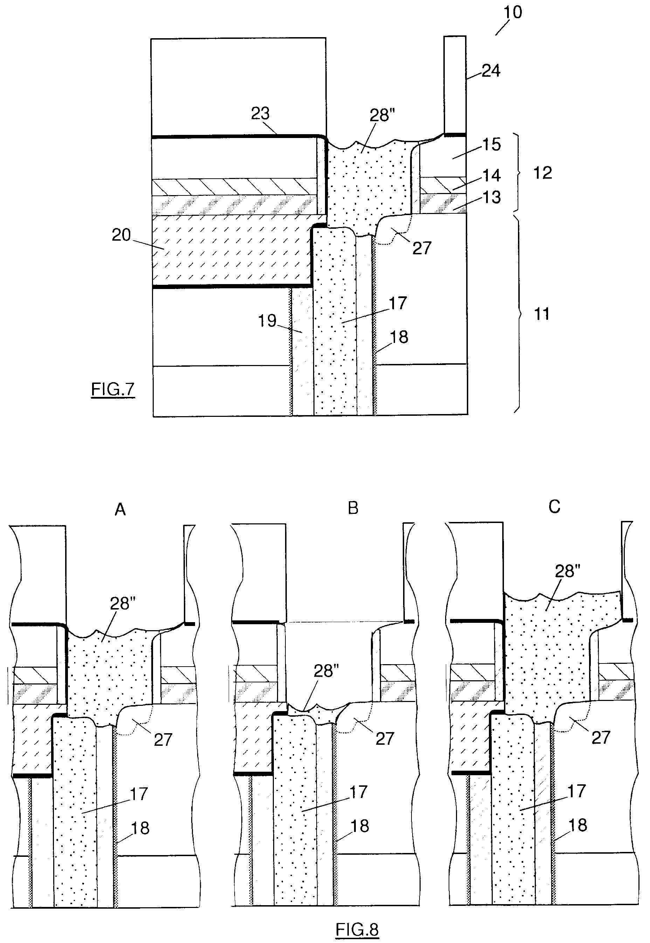

Then, the second sub-step is performed with the same operating conditions and in the same chamber to reduce the thickness of the doped polysilicon plug 28' into the strap opening 26 to produce the desired strap. As apparent in Fig. 7, the goal of this second sub-step is to have the top of the doped polysilicon strap referenced 28'' slightly below a level defined by the oxi-nitride liner 23 surface. These two etch sub-steps are monitored by means of an external interferometric etch endpoint system that uses two different wavelengths, one for each sub-step. This ends the polysilicon strap fabrication process.

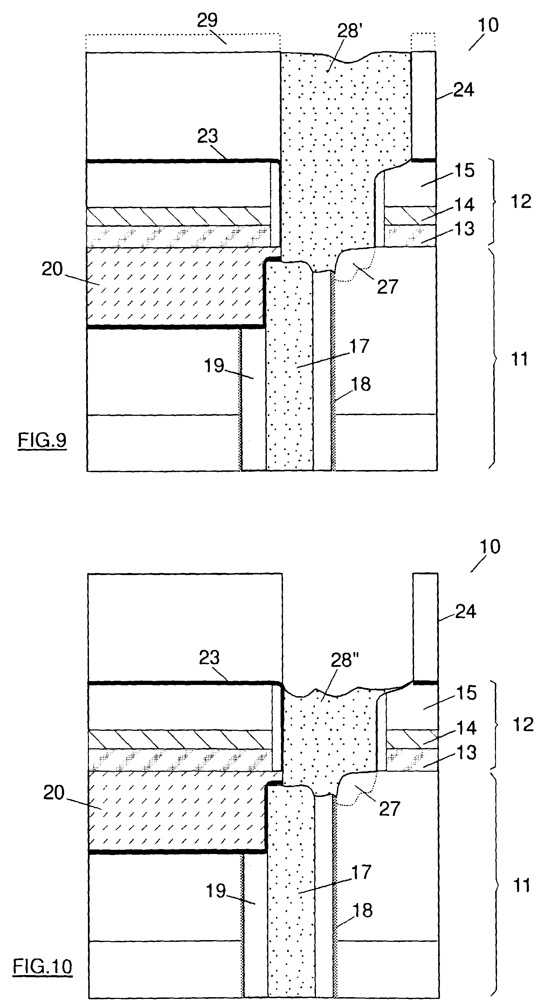

Unfortunately, the first sub-etch step has a very poor uniformity within a same wafer, typically 10% at one sigma. The etch rate uniformity depends on a number of factors, including, but not limitatively, the arsenic atoms distribution in the doped polysilicon layer 28, the chemistry used during the two etching sub-steps, the reactor design, and the chamber cleanliness conditions. As a consequence, the etch rate of the doped polysilicon layer 28 is very different depending the zone of the wafer being etched. Therefore, the first etch sub-step whose object is to coarsely "planarize" the doped polysilicon layer 28 can either leave or remove too much doped polysilicon depending the zone at the wafer surface. The first etch sub-step is fundamentally unaccurate because the relatively important thickness of doped polysilicon layer 28 (400 nm). Finally, when the second etch sub-step is performed, at the stage of the Fig. 6 structure, the thickness of the polysilicon plug 28' is very different, opening to opening, within the same wafer. After the two sub-steps of the etch process have been performed, as a first result of this non-uniformity, one can find "good" straps (Fig. 8A), "empty" straps (Fig. 8B) and "not etched enough" straps (Fig. 8C) in a same wafer. As far as "empty" straps are concerned, it is clear that the strap integrity is jeopardized. "Empty straps" cause so-called "OPEN" contacts, i.e. no electrical contact is possible between the capacitor top electrode and the IGFET drain region, which in turn, will subsequently result in non-functionnal memory cells. On the other hand, "not etched enough" straps prevent subsequent contact formation. These defective straps are a serious detractor to the final test yield.

In addition, as a second result of this etch non-uniformity, the etch end point detection in the first sub-step is not accurate.

### SUMMARY OF THE PRESENT INVENTION

It is therefore a primary object of the present invention to provide a method of plasma etching an arsenic doped polysilicon layer formed on a patterned BPSG layer with an uniform etch rate.

It is another object of the present invention to provide a method of forming an arsenic doped polysilicon strap in an opening of a patterned BPSG layer by plasma etching with a high level of thickness uniformity within a wafer.

It is still another object of the present invention to provide a method of forming an arsenic doped polysilicon strap in an opening of a patterned BPSG layer by plasma etching wherein the completion of the plasma etching process is very accurately and securely controlled by an optical etch end point system.

The accomplishment of these and other related objects is achieved by the method of the present invention which aims to get rid of these drawbacks. According to the method of the present invention, there is disclosed a combination of both system and process improvements that allow plasma etching of an arsenic doped polysilicon layer formed over a patterned layer of a dielectric such as BPSG with an uniform etch rate.

The system improvement consists to hold the wafer during the etch process with an electrostatic chuck device to have a perfect plasma environment around and above the wafer. For instance, the etch process can be run in an AME 5000 provided with an MxP oxide chamber which incorporates an "S3" electrostatic chuck device. On the other hand, the process improvement consists in the use of a non dopant sensitive and not selective chemistry. A NF3/CHF3/N2 gas mixture with a 11/8.6/80.4 ratio in percent is adequate in that respect. The etch time duration is very accurately controlled by an optical etch endpoint detection system adapted to detect the signal transition at the BPSG layer exposure. The process is continued by a slight overetch.

When the above method is applied to the doped polysilicon strap formation in DRAM chips, excessive or insufficient etching is avoided, so that the doped polysilicon strap thickness is thus much more uniform, opening to opening, within a wafer. As a result, the number of defective strap "empty" or "not etched enough" straps is strongly reduced thereby leading to a significant final test yield increase.

The novel features believed to be characteristic of this invention are set forth in the appended claims. The invention itself, however, as well as these and other objects and advantages thereof, will be best understood by reference to the following detailed description of an illustrated preferred embodiment to be read in conjunction with the accompanying drawings.

### BRIEF DESCRIPTION OF THE DRAWINGS

Figs. 1 to 7 show a semiconductor structure undergoing the doped polysilicon strap formation steps sequence.
Fig. 8 is comprised of Figs. 8A, 8B and 8C which respectively show "good", "empty" and " "not etched enough" doped polysilicon straps.
Figs. 9 and 10 show the semiconductor structure of Fig. 5 undergoing the doped polysilicon strap formation wherein the plasma etching step is now performed according to the method of the present invention.

### DESCRIPTION OF A PREFERRED EMBODIMENT

Applicant's inventors have discovered that the plasma etching process of the prior art could be significantly improved only if both the wafer plasma environment and the etching chemistry were changed during the first sub-etch step.

Firstly, the etching of the doped polysilicon layer must be conducted with a plasma that is perfectly uniform all over the wafer surface and this can be obtained only if the wafer is placed on an electrostatic chuck device (ECD). Electrostatic wafer holding has become very desirable in the vacuum handling and processing of semiconductor wafers for a number of reasons. However, the specific feature which is important here is only the absence of clamps (or grippers) that are of general use on the other types of wafer holders. The absence of clamps has been appreciated so far as a source of contamination reduction. Without clamps, less cracks are produced in the wafer during the handling and processing operations. As a result, it has been noticed less wafer contamination by silicon particles. Applicant' inventors have observed that these clamps also cause some deformations in the plasma environment above the wafer which become detrimental in the above described etching process.

Secondly, it has been experimentally demonstrated that to improve the process of etching an arsenic doped polysilicon layer formed on a patterned BPSG layer with a uniform etch rate, (1) the chemistry must not be dopant sensitive, i.e. the chemistry must have the same etch rate irrespective the concentration or distribution of arsenic atoms in the doped polysilicon layer and (2), unexpectedly, it must not be selective between the doped polysilicon and the BPSG material. An NF3/CHF3/N2 etch chemistry was found to be adequate in that respect.

When both system and process improvements are implemented, the new etch process is able to provide a perfectly planarized structure at the end of the first sub-step of the doped polysilicon etch process irrespective the zone at the wafer surface in consideration. This is a direct result of the drastic improvement in terms of thickness removal uniformity. There is no change in the second etch sub-step operating conditions, although it is in essence a poorly uniform process but, because it is performed in a relatively short time, it will not be detrimental to the whole etch process. As a final result, the doped polysilicon strap thickness being much more uniform, opening to opening, within the same wafer, the number of "empty" and "not etched enough" straps is strongly reduced leading to a significant final test yield increase.

The novel two-steps etch process is described in details below. It was run in the MxP oxide chamber of the AME 5000 mentioned above that has an "S3" electrostatic chuck device with a quartz focus ring.

Process parameters for the first sub-etch step are given below. A NF3/CHF3/N2 gas mixture with a 11/8.6/80.4 ratio in percent is adequate in all respects to reduce to practice the method of the present invention.
- NF3: : 9 sccm
- CHF3: : 7 sccm
- N2: : 65 sccm
- Pressure: : 50 mTorr
- RF power: : 500 watt

The NF3/CHF3 ratio (typically 9:7) is of great importance. N2 is an inert gas used as a carrier to dilute the active components of this gas mixture. This chemistry is not selective. As a matter of fact, it etches the doped polysilicon at 105 nm/min and the BPSG material at 120 nm/min. It should be noted that this chemistry is also effective for other dielectric materials such as TEOS SiO2 and Si3N4.

When BPSG (or TEOS SiO2) material is used, the etch process is preferably controlled by an optical etch end point detection which can detect very accurately and securely the exposure of the BPSG underlying layer as it will be now described in more details. The emission of the CO line (483.5 nm) has been selected. The emitted power of this emission is very low during all the first sub-step etch operation to etch the doped polysilicon layer 28. As soon as the BPSG layer 24 top surface is reached, the carbon from the CHF3 and the oxygen of the BPSG material combines together to produce an immediate CO emission which increases very fastly, producing thereby a very sharp intensity signal transition. As a consequence, the total removal of the doped polysilicon layer 28 above the BPSG layer 24 is instantaneously detected. The doped polysilicon removal operation can be monitored by the optical etch end point system mounted in the AME 5000 tool although an external monitoring system could be used as well. Using the novel operating conditions as recited above, the etch duration is about 200 s. The etch rate of the doped polysilicon layer 28 has become very uniform over the totality of the wafer surface, typically about 2% at one sigma (to be compared with the 10% reported above with the prior art technique), so that the doped polysilicon plug 28' thickness is substantially constant in all the strap openings 26 within a same wafer.

The etching is continued a few nanometers below the BPSG layer 24 top surface by a slight overetching. This overetching is used to be sure that the duration of the second sub-step will be the shortest possible. The NF3/CHF3/N2 chemistry being not selective, the BPSG material and the doped polysilicon material are removed substantially at the same rate, maintaining thereby the excellent etch uniformity and the planarity that were previously obtained. An overetch of 13% (26 s) has been experimentally determined through engineering tests and demonstrated to be adequate. As apparent in Fig. 9, this overetching removes the superficial portion referenced 29 of BPSG layer 24 because of its low selectivity. However, the remaining thickness of BPSG layer 24 is suffisant in all respects to perform the subsequent steps of the wafer fabrication process. During the overetching, the respective doped polysilicon and BPSG etch rates continue to be very similar.

Now, the second sub-step is performed in the AME 5000 Mark II mentioned above and with the same operating conditions. Because the duration of the second sub-step is very short (typically 20 s), the excellent uniformity that was obtained after the first sub-etch is preserved. The finished structure is shown in Fig. 10.

## Claims

1. A method of plasma etching an arsenic doped polysilicon layer formed on a patterned boro-phospho-silicate-glass (BPSG) layer overlying a substrate wherein said patterned BPSG layer is provided with at least one opening comprising the steps of:
a) providing a plasma etch reactor having an electrostatic chuck device whereupon the substrate is mounted;
b) providing a plasma within said reactor containing a non-dopant sensitive, not selective NF3/CHF3 etching mixture and an inert gas carrier gas wherein the NF3/CHF3 ratio is approximately 9:7; and,
c) exposing the doped polysilicon to said plasma for a time sufficient to etch the doped polysilicon layer down to approximately the BPSG top surface.

2. The method of claim 1 wherein said NF3/CHF3/N2 etching mixture has approximately the 11/8.6/80.4 ratio in percent.

3. The method of claim 1 wherein the plasma etching is continued a short time to perform a slight overetching of the doped polysilicon in the opening.

4. The method of claim 3 wherein the overetching duration is equal to about 13% of the duration of the plasma etching step.

5. The method of claim 1 wherein the exposure of the BPSG layer is detected by the sharp transition of the intensity signal emitted by the CO line.
